# FASCICULE DE BREVET EUROPEEN

(11) **EP 2 353 177 B1**
(45) Date de publication et mention de la délivrance du brevet: **13.03.2013**
(21) Numéro de dépôt: 09760543.0
(22) Date de dépôt: 27.10.2009
(51) Int. Cl.: H01L 21/268

(54) **PROCEDE ET DISPOSITIF DE CHAUFFAGE D'UNE COUCHE D'UNE PLAQUE PAR AMORCAGE ET FLUX LUMINEUX.**
VERFAHREN UND EINRICHTUNG ZUR ERHITZUNG EINER SCHICHT EINER PLATTE DURCH AUFTAKTUNG UND LICHTFLUSS
METHOD AND DEVICE FOR HEATING A LAYER OF A PLATE BY PRIMING AND LIGHT FLOW

(30) Priorité: 04.11.2008 FR 0857476
(43) Date de publication de la demande: 10.08.2011
(73) Titulaire: Soitec, 38190 Bernin (FR)
(72) Inventeur: BRUEL, MIchel, F-38113 Veurey Voroize (FR)
(74) Mandataire: Regimbeau
(86) Numéro de dépôt international: PCT/FR2009/052069
(87) Numéro de publication internationale: WO 2010/052408

(56) Documents cités:
- FR-A1- 2 921 752
- US-A- 4 234 356

## Description

La présente invention se rapporte au domaine technique général du traitement de matériau, en particulier dans le domaine des couches minces, des plaquettes, des lames ou des lamelles de matériau, notamment de semi-conducteurs, en particulier de silicium.

Plus particulièrement, la présente invention se rapporte au domaine de l'application de traitements thermiques à des pièces au moyen de flux de lumière.

Dans l'état actuel de la technique, il existe des connaissances et procédés faisant appel à des flux de lumière pour réaliser des traitements thermiques, dans lesquels l'absorption des flux de lumière se produit à la surface extérieure et/ou au voisinage de la surface extérieure des pièces et le chauffage des parties plus profondes a lieu par diffusion thermique depuis la surface extérieure et/ou de son voisinage recevant le flux de lumière vers les zones plus profondes de la pièce à traiter.

La caractéristique de ces procédés de l'état de la technique est que les flux de lumière utilisés sont choisis de telle sorte que le matériau à traiter soit naturellement absorbant vis-à-vis du flux de lumière ou rendu absorbant par l'interaction directe du flux de lumière avec le matériau de la pièce, par exemple en utilisant des niveaux de puissance extrêmement élevés.

L'usage de flux de lumière s'avère particulièrement utile quand on veut pouvoir chauffer une couche superficielle pendant des temps très courts, de l'ordre de la fraction de microseconde à quelques dizaines de microsecondes.

Néanmoins, l'épaisseur chauffée évoluant en général comme la racine carrée du temps depuis la surface extérieure de la pièce, il est extrêmement difficile et coûteux de chauffer des parties profondes de la pièce et ce de plus en plus difficile et coûteux au fur et à mesure qu'on s'intéresse à des profondeurs plus grandes.

De plus, le profil thermique obtenu dans la pièce présentant de façon générale un maximum à la surface extérieure et décroissant dans le matériau à partir de cette surface extérieure, il est nécessaire de limiter la température de surface à la température maximum que le matériau ne doit pas dépasser dans le cadre du procédé, par exemple la température de fusion ou de vaporisation ou de décomposition du matériau. Cette limite impose des flux modérés de puissance lumineuse et des grandes durées et donc des coûts élevés.

Par ailleurs, le brevet WO 03/075329 propose de chauffer une sous-couche absorbante par un flux lumineux au travers d'une couche antérieure. Après quoi, la chaleur produite dans la sous-couche chauffe par diffusion la couche antérieure, à une température inférieure à celle atteinte dans la sous-couche.

Le brevet US 4 234 356 décrit un procédé de chauffage dans lequel un premier faisceau, émis en direction d'une paroi d'une couche, est apte à élever la température de cette paroi jusqu'à une température provoquant sa fusion, et dans lequel un second faisceau, émis en direction de la paroi opposée de la couche et qui présente la caractéristique de ne pas être absorbé par le matériau à l'état solide et d'être absorbé par le matériau à l'état liquide, maintient à l'état liquide la partie de la couche qui a été mise en fusion par le premier faisceau.

Le brevet WO 2009/050381 décrit un procédé de chauffage d'une plaque par un flux lumineux.

La présente invention a pour objet un procédé de chauffage, au moins local, d'une plaque comprenant au moins une couche à chauffer au moins localement, jusqu'à un niveau de température à atteindre, sous l'effet d'au moins une impulsion d'un flux lumineux principal, et comprenant au moins une région d'amorçage située en profondeur par rapport à une face frontale de ladite couche à chauffer.

Dans le procédé ci-dessus, la longueur d'onde dudit flux lumineux principal est choisie de telle sorte que le coefficient d'absorption de ce flux par la matière de la couche à chauffer est faible tant que la température de la matière de cette couche à chauffer est dans une plage basse de température (PBT) et que ce coefficient d'absorption augmente fortement avec la température quand la température de la matière de la couche à chauffer passe dans une plage haute de température (PHT) située approximativement au-dessus de cette plage basse de température, la zone de transition (TT) entre la plage basse de température (PBT) et la plage haute de température (PHT) étant située au-dessous dudit niveau de température à atteindre, les caractéristiques dudit flux lumineux principal étant telles qu'il est, à lui seul, inapte à chauffer directement la matière de la couche à chauffer depuis une température située dans ladite plage basse de température (PBT) jusqu'à une température située dans ladite plage haute de température (PHT).

Selon le procédé ci-dessus de l'invention, ladite région d'amorçage de ladite plaque est chauffée, au moins partiellement, sous l'effet d'un moyen de chauffage secondaire d'amorçage, de telle sorte que ladite région d'amorçage chauffe par diffusion thermique une partie de la couche à chauffer adjacente à ou proche de cette région d'amorçage jusqu'à une température située dans ladite plage haute de température (PHT) pour rendre cette partie fortement absorbante dudit flux principal lumineux.

Ledit flux principal lumineux est appliqué à ladite plaque, au moins localement, par ladite face frontale de ladite couche à chauffe, de telle sorte que, ladite partie adjacente à ou proche de ladite couche à chauffer, devenue fortement absorbante, générant un front thermique absorbant dont la température est située dans ladite plage haute de température (PHT), ce front thermique absorbant progresse vers ladite face avant sous l'effet conjugué d'une diffusion thermique vers l'avant du front thermique et d'un apport d'énergie thermique par ledit flux lumineux qui atteint ce front thermique dès lors que la température du front thermique passe dans ladite plage haute de température (PHT).

Le début de l'application dudit flux principal lumineux peut correspondre approximativement à la fin de l'application dudit moyen de chauffage secondaire d'amorçage.

Le début de l'application dudit flux principal lumineux peut être situé avant la fin de l'application dudit moyen de chauffage secondaire d'amorçage.

Ledit flux principal lumineux peut être choisi de façon à être absorbé par ladite région d'amorçage, le chauffage de ladite région d'amorçage étant réalisé sous l'effet dudit moyen de chauffage secondaire d'amorçage et sous l'effet dudit flux principal lumineux.

Ledit moyen de chauffage secondaire d'amorçage peut être appliqué par ladite face frontale de ladite couche à chauffer et/ou par une face de ladite plaque opposée à cette face frontale.

Ledit moyen de chauffage secondaire d'amorçage peut être un flux thermique généré par une source de chaleur.

Ledit moyen de chauffage secondaire d'amorçage peut être un flux de particules, ladite région d'amorçage étant chauffée par l'énergie résultant du freinage et/ou de l'arrêt de ces particules dans ladite région d'amorçage.

Ledit moyen de chauffage secondaire d'amorçage peut être un flux de rayonnement, ladite région d'amorçage étant chauffée par absorption de ce rayonnement.

Ladite région d'amorçage peut être formée par une partie de ladite couche à chauffer.

Ladite région d'amorçage peut être formée par une sous-couche adjacente à ou proche de ladite couche à chauffer.

Ladite plage basse de température (PBT) et ladite plage haute de température (PHT) peuvent être séparées par un seuil de transition de comportement du coefficient d'absorption en fonction de la température.

Ledit seuil de transition de comportement du coefficient d'absorption en fonction de la température peut s'étendre sur une plage de température.

La couche à chauffer peut être du silicium peu dopé.

La couche à chauffer peut être un matériau semi-conducteur.

Ladite plage basse de température (PBT) peut correspondre sensiblement à la plage dans laquelle le dopage n'est pas intrinsèque et que ladite plage haute de température (PHT) correspond sensiblement à la plage dans laquelle le dopage est intrinsèque.

Le flux principal lumineux peut être généré par un laser.

La présente invention sera mieux comprise à l'étude de procédés et de dispositifs de traitements thermiques de plaques, décrits à titre d'exemples non limitatifs et illustrés par le dessin sur lequel :
- la figure 1 représente une coupe d'une plaque à région d'amorçage et un appareillage associé pour produire un flux lumineux principal et un flux lumineux d'amorçage ;
- la figure 2 représente en fonction du temps l'intensité d'un flux d'amorçage et d'un flux principal dans le cas où le début du flux principal coïncide avec la fin du flux d'amorçage ;
- la figure 3 représente en fonction du temps l'intensité d'un flux d'amorçage et d'un flux principal dans le cas où le début du flux principal intervient postérieurement à la fin du flux d'amorçage ;
- la figure 4 représente en fonction du temps l'intensité d'un flux d'amorçage et d'un flux principal dans le cas où le début du flux principal intervient avant la fin du flux d'amorçage ;
- la figure 5 représente un diagramme de l'évolution de la température dans l'épaisseur d'une plaque ;
- la figure 6 représente une autre disposition d'un flux d'amorçage et d'un flux principal ;
- la figure 7 montre une variante d'une région d'amorçage ;
- la figure 8 montre une autre variante d'une région d'amorçage ;
- la figure 9 montre une autre variante d'une région d'amorçage ;
- et la figure 10 représente une autre variante d'application d'un flux d'amorçage et d'un flux principal.

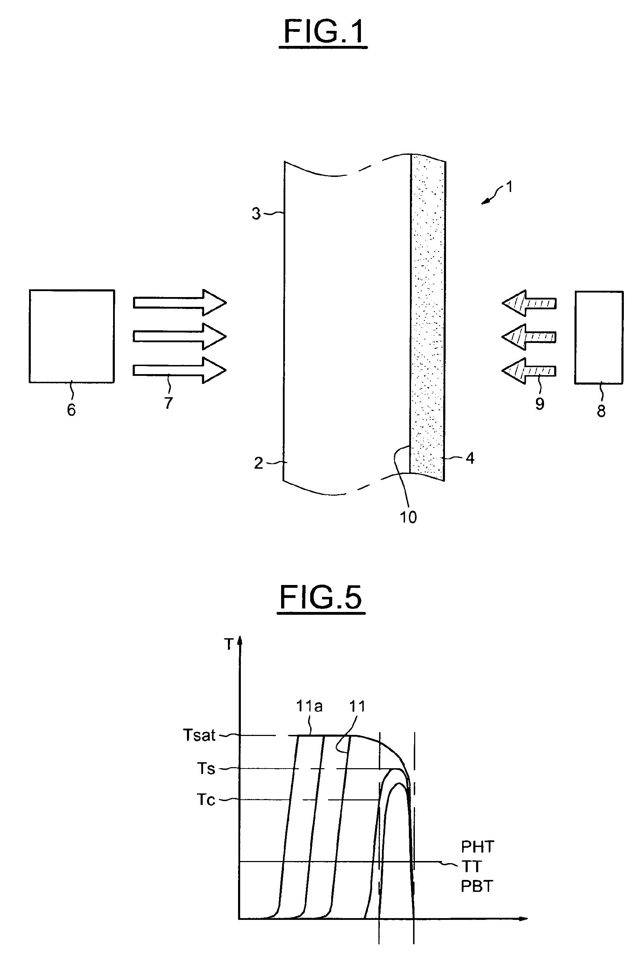

On a représenté sur la **figure 1** une plaque 1 qui comprend une couche 2 à chauffer, par exemple jusqu'à un niveau de température Tsat (figure 5), qui présente une face avant 3, et une sous-couche d'amorçage 4, par exemple en une matière différente de la couche à chauffer 2, accolée à la face arrière 5 de la couche 2.

En face de la face avant 3 de la couche 2 est installé un générateur principal 6 d'impulsions Pp d'un flux principal lumineux 7 vers cette face avant 3.

La couche à chauffer 2 et le flux principal lumineux 7 sont choisis l'un par rapport à l'autre de façon à présenter les caractéristiques suivantes.

La longueur d'onde du flux principal lumineux 7 est telle que le coefficient d'absorption de ce flux par la couche 2 est faible tant que la température T de la matière de cette couche 2 est dans une plage basse de température PBT et que ce coefficient d'absorption augmente fortement avec la température quand la température T de la matière de la couche 2 passe dans une plage haute de température PHT située approximativement au-dessus de cette plage basse de température PBT. La plage basse de température PBT et la plage haute de température PHT présentent naturellement une zone de transition TT (figure 5).

Les caractéristiques du flux lumineux 7, en particulier sa durée et son intensité, sont en outre telles qu'à lui seul, ce flux principal lumineux 7 est inapte à chauffer directement la couche à chauffer 2 depuis une température située dans la plage basse de température PBT jusqu'à une température située dans la plage haute de température PHT.

De plus, la zone de transition (TT) entre la plage basse de température (PBT) et la plage haute de température (PHT) peut être située au-dessous dudit niveau de température à atteindre Tsat.

Du côté et en face de la sous-couche d'amorçage 4 est installé un générateur secondaire 8 d'impulsions d'amorçage Ps d'un flux secondaire lumineux 9 d'amorçage vers cette sous-couche 4.

La sous-couche d'amorçage 4 et le flux secondaire lumineux d'amorçage 9 sont choisis l'un par rapport à l'autre de façon à présenter les caractéristiques suivantes.

Le flux secondaire lumineux d'amorçage 9 et le coefficient d'absorption par la sous-couche d'amorçage 4 de ce flux secondaire lumineux 9 sont choisis l'un par rapport à l'autre de façon qu'au moins une partie de la sous-couche d'amorçage 4 soit chauffée sous l'effet du flux secondaire lumineux d'amorçage 9. Ainsi chauffée, la sous-couche d'amorçage 4 peut chauffer par diffusion thermique une partie 10 de la couche à chauffer 2 adjacente à la sous-couche d'amorçage 4 jusqu'à une température située dans la plage haute de température PHT pour rendre cette partie fortement absorbante, cette température pouvant être située au-dessous dudit niveau de température à atteindre.

Par exemple, la sous-couche d'amorçage 4 et le flux secondaire lumineux d'amorçage 9 peuvent être choisis l'un par rapport à l'autre pour que le coefficient d'absorption de la sous-couche d'amorçage 4 soit élevé aussi bien dans la plage basse de température PBT que dans la plage haute de température PHT.

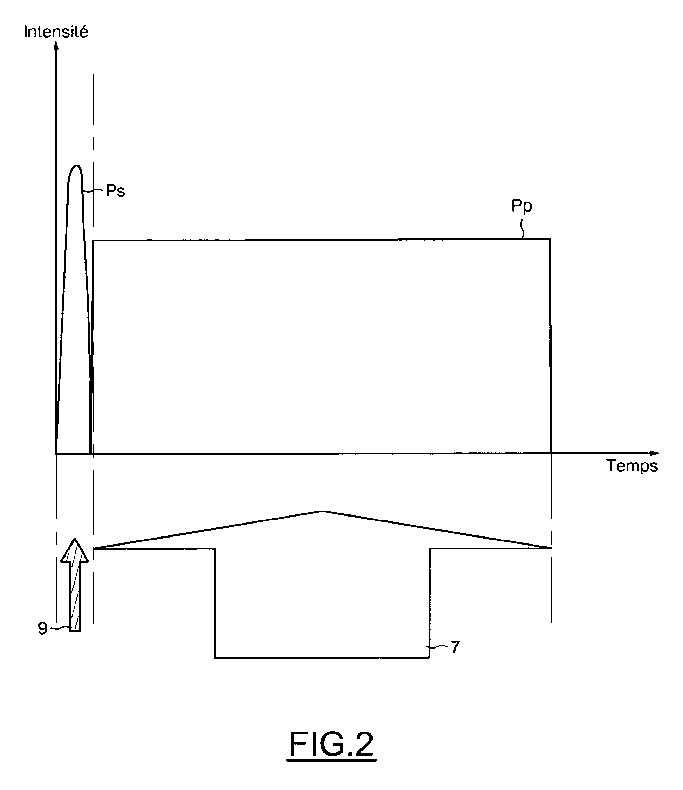

Selon une variante représentée sur la **figure 2**, le flux principal lumineux 7 peut être appliqué juste à la suite du flux secondaire lumineux d'amorçage 9.

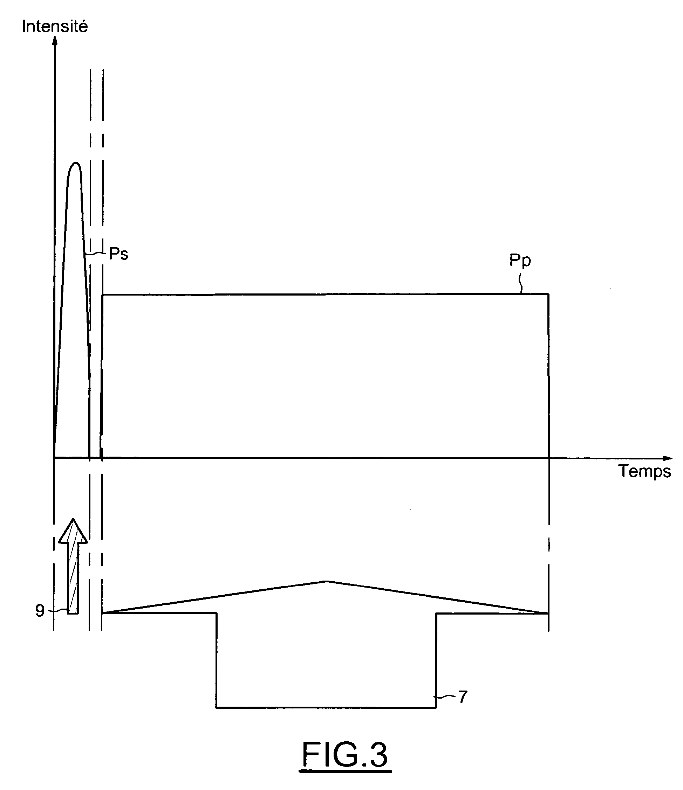

Selon une variante représentée sur la **figure 3**, le flux principal lumineux 7 peut être appliqué à la suite du flux secondaire lumineux d'amorçage 9, avec un laps de temps entre eux.

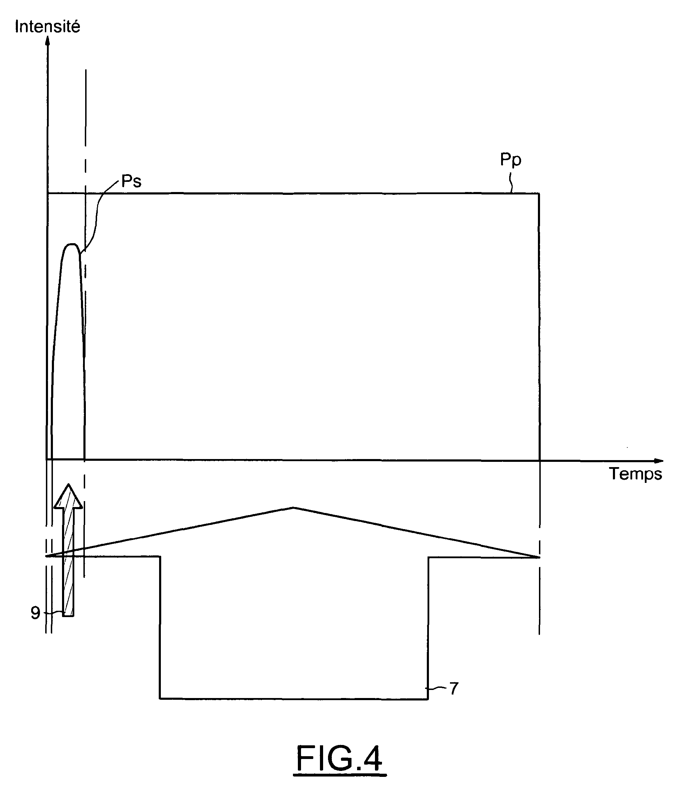

Selon une variante représentée sur la **figure 4**, le flux principal lumineux 7 peut être appliqué de telle sorte que son début d'application soit situé avant la fin de l'application du flux secondaire lumineux d'amorçage 9 et se poursuive après cette fin. Dans ce cas, il peut être avantageux que la sous-couche d'amorçage 4 soit apte à absorber le flux principal lumineux 7 de telle sorte que ce dernier participe au chauffage souhaité de la sous-couche d'amorçage 4.

En appliquant le flux secondaire lumineux d'amorçage 9 et le flux principal lumineux 7 conformément aux variantes ci-dessus, le mécanisme qui se produit peut être le suivant, ce mécanisme étant illustré schématiquement sur la **figure 5**, en correspondance avec la figure 1.

Le chauffage de la sous-couche 4, sous l'effet du flux secondaire lumineux d'amorçage 9 (figures 2 ou 3) ou de ce flux secondaire lumineux d'amorçage 9 et d'une première partie du flux principal lumineux 7 (figure 4), à une température Ts située dans la plage haute de température PHT au moins dans une partie de son épaisseur, engendre le chauffage par diffusion thermique de la partie 10 de la couche à chauffer 2 adjacente à la sous-couche 4, jusqu'à une température située dans la plage haute de température PHT.

La partie 10 de la couche à chauffer 2, à une température Tc située dans la plage haute de température PHT, est ainsi rendue fortement absorbante et génère en profondeur l'amorçage d'un front thermique absorbant 11.

Le flux principal lumineux 7, appliqué par la face avant 3 de la couche à chauffer 2, pénètre dans la couche à chauffer 2 et atteint ce front thermique absorbant 11.

Ce front thermique absorbant 11 progresse alors vers la face avant 3 sous l'effet conjugué d'une diffusion thermique vers l'avant du front thermique absorbant 11 et d'un apport d'énergie thermique par le flux principal lumineux 7 qui atteint ce front thermique au travers du reste non fortement absorbant de la couche à chauffer 2 et apte encore à être traversé par le flux principal lumineux 7.

Au cours de la progression du front thermique, la température maximum du front thermique tend progressivement à se stabiliser, vers une valeur sensiblement constante Tsat à atteindre, située au-dessus de Ts et de Tc. Pendant la progression du front thermique 11, à un instant donné, le profil de température dans la couche à chauffer 2 est composé d'une partie abrupte correspondant au front thermique 11 et une partie 11a sensiblement plate correspondant à Tsat sur l'épaisseur de la couche à chauffer déjà parcourue par le front thermique 11.

A titre d'exemple, si la couche 2 est du silicium cristallin et que le flux principal 7 est un flux de laser CO2, Tsat peut être de l'ordre de 1500K avec des flux de 2 à 5 E6W /Cm2, Tsat pouvant être égal à la température de fusion de 1687 K avec fusion complète du silicium pour des flux de l'ordre de 1,5 à 3 E7W /Cm2.

La température Tsat dépend du flux principal 7, mais aussi du flux d'amorçage 9 et du mécanisme d'amorçage. Pour connaître une valeur plus précise de Tsat, il convient de résoudre l'équation de la chaleur à une dimension, par la méthode des différences finies connue de l'homme de l'art, à l'aide de logiciels standard du commerce

Lorsque le flux principal lumineux 7 s'arrête, la progression du front thermique 11, selon ce mode de propagation, cesse quasi immédiatement dans la couche 2 s'il n'a pas atteint la face avant 3. L'évolution du front thermique 10 devient alors gouvernée uniquement par les effets de diffusion thermique.

Dans des conditions particulières d'un flux de lumière 7 constant, le chauffage de la couche 2 se produit sur une épaisseur sensiblement en relation linéaire avec la durée du flux thermique.

L'enchaînement des phases décrites ci-dessus n'exclut pas un recouvrement temporel partiel des phases ci-dessus.

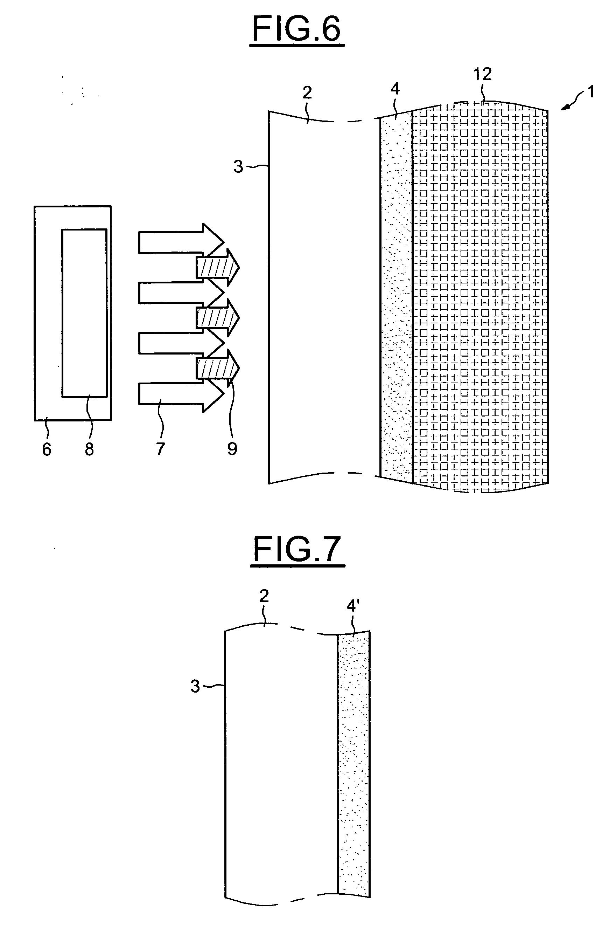

Dans une variante de réalisation représentée sur la **figure 6**, dans laquelle, par exemple, la plaque 1 peut présenter en outre une couche arrière 12 ne pouvant pas être traversée par le flux secondaire 9, les générateurs 6 et 8 sont placés du côté de la face 3 et le flux secondaire lumineux d'amorçage 9 est appliqué à la sous-couche 4 par l'avant au travers de la couche à chauffer 2, la couche à chauffer 2 ne pouvant pas être chauffée par absorption du flux secondaire lumineux d'amorçage 9. Le mécanisme de chauffe de la sous-couche 4 et de la couche à chauffer 2 se produit comme décrit plus haut.

Dans une variante de réalisation représentée sur la **figure 7**, la sous-couche 4 peut être formée par une partie arrière d'amorçage 4' de la couche à chauffer 2, cette partie arrière étant apte à être chauffée par absorption du flux secondaire lumineux d'amorçage 9 pour que le mécanisme de chauffe se produise comme décrit plus haut. Dans ce cas, la région d'amorçage peut-être définie comme la partie 4' de la couche à chauffer 2, dont la température sera amenée dans la plage haute de température PHT à la fin du flux d'amorçage sous l'effet du flux d'amorçage 9.

Dans les variantes qui viennent d'être décrites, la sous-couche 4 constitue en totalité une région d'amorçage. Néanmoins, cette région pourrait être morcelée.

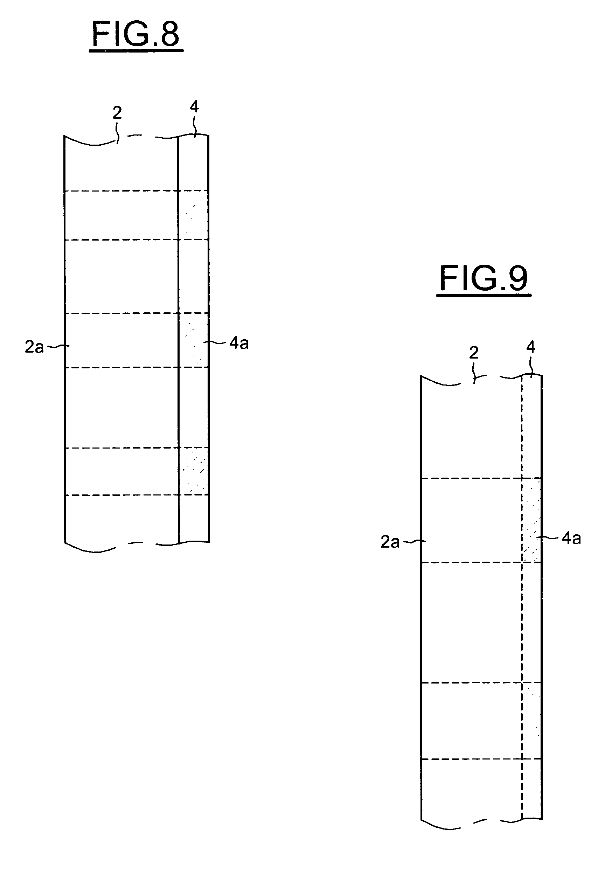

Comme le montre la **figure 8**, la région d'amorçage pourrait être formée par uniquement une partie ou des parties 4a d'une telle sous-couche, ces parties 4a étant aptes à être chauffée par absorption du flux secondaire lumineux d'amorçage 9. Comme le montre la **figure 9**, la région d'amorçage pourrait être formée par uniquement une partie ou des parties arrière 4a d'amorçage de la couche à chauffer 2, ces parties 4a étant aptes à être chauffée par absorption du flux secondaire lumineux d'amorçage 9. Dans ces exemples, la couche à chauffer 2 pourrait être chauffée uniquement dans ses parties 2a situées au-dessus des parties 4a de la sous-couche 4.

### Exemples de mise en oeuvre.

Le matériau transparent constituant la couche à chauffer 2 peut être du silicium dopé à un niveau de l'ordre de 1.E15/Cm3 à 5.E15/Cm3 et placé initialement à la température ambiante.

Le flux principal lumineux 7 peut être une impulsion de laser CO2 de durée 6 microsecondes avec un flux de 3,75 * 1.E6 W/Cm2.

L'absorption d'un flux de laser CO2 dans du silicium est gouvernée pour l'essentiel par la densité de porteurs électriques. Dans les conditions décrites ici, le coefficient d'absorption du silicium est de l'ordre de quelques Cm-1, ce qui est faible et reste sensiblement constant tant que la température du silicium n'atteint pas environ 270°C. A partir environ de cette température, la concentration intrinsèque de porteurs devient supérieure à 1*E15 Cm-2 (Voir le document intitulé « Physics of Semiconductor Devices », second Edition, N°ISBN 0-07-062735-5, par S.M. SZE, John Wiley and Sons, page 20 - fig. 12 et page 26 - fig. 16) et augmente fortement avec la température.

La plage basse de température PBT est donc la plage de température sensiblement située au-dessous de la limite inférieure de température LIT égale à environ 270°C, tandis que la plage haute de température PHT est la plage sensiblement située au-dessus de 270°C. Conformément au document ci-dessus, la plage basse de température PBT est située dans le domaine non intrinsèque, de saturation et/ou de gel des porteurs et la plage haute de température PHT est située dans le domaine intrinsèque.

Le matériau constituant la sous-couche d'amorçage peut être du silicium faiblement dopé et le flux secondaire d'amorçage 9 peut être, par exemple, un flux d'électrons de 50kev avec une densité de courant de l'ordre de 50 à 100A/Cm2, un flux de laser excimere à la longueur d'onde d'environ 360nm, un flux de laser YAG doublé en fréquence (longueur d'onde environ 503 nm) ou triplé en fréquence (longueur d'onde environ 353 nm).

Dans un autre mode de réalisation, le matériau constituant la sous-couche 4 peut être du silicium dopé à un niveau de l'ordre de 3.E19/Cm3, donc différent de la matière de la couche à chauffer 2 choisie, et placé initialement à la température ambiante et le flux d'amorçage un flux de laser CO2 ; dans ces conditions, le coefficient d'absorption du flux d'amorçage dans la sous-couche 4 est de l'ordre de 1000 Cm-1. L'épaisseur de la sous-couche 4 peut être d'environ 10 µm.

Selon un premier exemple d'obtention de la plaque 1, on réalise un substrat de silicium dopé à 1*E15Cm-3 et d'épaisseur égale à 100 µm par amincissement d'une plaquette de silicium standard. On réalise, à travers l'une des faces, une implantation d'ions de bore à une dose de quelque 3*E16 /Cm2 à l'énergie de 200 keV et on réalise un recuit à une température de 1000°C à 1100°C environ pendant deux heures de façon à atteindre une profondeur de dopage de 10 microns environ pour obtenir la sous-couche 4, l'épaisseur restante de 90µm constituant la couche à chauffer 2, la couche 2 et la couche 4 étant donc en des matières différentes. La face non utilisée pour l'implantation constitue alors la face 3 au travers de laquelle le flux principal de lumière 7, et éventuellement le flux secondaire 9, seront appliqués.

Alternativement, dans le cadre de ce premier exemple, on réalise un substrat de silicium dopé à 1*E15Cm-3 et d'épaisseur égale à 90 µm par amincissement d'une plaquette de silicium standard. On réalise, sur l'une des faces une épitaxie de silicium dopé au niveau de quelques 5*E19/Cm3 et d'épaisseur 10 microns. Cette couche épitaxiée constitue alors la sous-couche 4 et est donc en une matière différente de celle de la couche 2 à chauffer.

Selon un second exemple d'obtention de la plaque 1, on réalise, sur un substrat de silicium standard, une épitaxie de silicium dopé en antimoine à 2*E19/Cm3 et de 10 microns d'épaisseur pour constituer la sous-couche 4. Ensuite, au-dessus de l'épitaxie de 10 microns, on réalise une épitaxie de silicium dopé à 1*E15/Cm3 et de 90 microns d'épaisseur pour constituer la couche 2.

A titre d'exemples complémentaires, le matériau absorbant constituant la sous-couche 4 aurait pu être aussi, dans le cas où on utilise un laser CO2, une couche amorphe de silicium, une couche totalement ou partiellement amorphisée par implantation ionique, ou une couche d'oxyde de silicium SiO2, donc différent de la matière de la couche à chauffer 2 choisie.

Si l'on imagine une pièce constituée exclusivement de la couche 2, sans la sous-couche 4, et que l'on applique le flux de lumière défini plus haut, on peut constater que la température du matériau augmente de moins de 30°C. Ce résultat peut résulter d'une simulation par résolution de l'équation de la chaleur par une méthode dite des différences finies, méthode qui fait partie de l'état de l'art.

Ce résultat aurait pu être obtenu aussi en appliquant le formalisme simple suivant :
- identification de la valeur maximum Alphamax du coefficient d'absorption sur la plage basse de température PBT
- l'ordre de grandeur de la température maximum atteinte Tmax peut alors être donnée par la formule Tmax=Phi*tau*alphamax/Cp
dans laquelle Cp est la capacité calorifique, Phi est le flux, Tau est la durée du flux, Cp la chaleur volumique,

Et avec Phi égal à 3,75*1.E6W/Cm2, tau égal à 6*1.E-6 S, alphamax égal à 2Cm-1 et Cp égal à 1,4 J/Cm3.

On trouve alors que l'ordre de grandeur de la température maximum Tmax atteinte de la couche 2 unique est égal à 32 °C.

On constate bien qu'à titre général, dans ces conditions, la température de la couche à chauffer 2 reste très faible et à l'intérieur de la plage basse de température PBT, sans atteindre la plage haute de température PHT.

Par contre, en présence de la sous-couche 4, il est possible de chauffer une grande épaisseur du matériau transparent constituant la couche à chauffer 2 jusqu'à des températures de l'ordre de 1650K, par exemple, sur des épaisseurs de l'ordre de 60 µm.

### Exemples d'application.

### Exemple 1.

Partant d'une plaquette-support (couche arrière 12) en silicium de qualité métallurgique, on dépose sur la surface de cette plaquette, par une technique de dépôt CVD, une couche 4 de deux microns d'épaisseur dopé à 5*1.E19 /Cm3 et par-dessus une couche épaisse 2 de silicium non dopé polycristallin d'épaisseur 60 microns, la couche 2 et la couche 4 étant donc en des matières différentes. Ainsi, à la température ambiante, cette couche 2 à chauffer est sensiblement transparente un flux lumineux généré par un laser CO2 et la sous-couche 4 est absorbante d'un tel flux lumineux.

La présence de la plaquette-support 12 en silicium métallurgique empêche d'utiliser la face arrière pour envoyer le flux d'amorçage 9. Le flux d'amorçage 9 est donc envoyé par la face avant 3, ainsi que le flux principal 7, comme décrit plus haut en référence à la **figure 6**.

Le flux d'amorçage 9 peut être une impulsion de laser CO2 de durée 50 nS et d'intensité 2*1.E7W/cm2. Celle-ci peut être générée par exemple par un laser CO2 à excitation transverse.

Par exemple simultanément comme le montre la **figure 4**, on applique le flux lumineux principal 7 issu d'un laser CO2, par exemple un laser de très forte puissance à excitation longitudinale, par la face avant 3 de la couche à chauffer 2, par exemple localement sur une ou plusieurs zones. La durée du flux principal 7 est par exemple de deux microsecondes avec une intensité de 3.E7W/cm2.

A titre de variante de la figure 4, le flux d'amorçage 9 peut intervenir dans cet exemple pendant le temps de montée en puissance du flux principal 7 qui peut être de l'ordre de 100nS, le temps de montée du flux d'amorçage 9 étant, lui, beaucoup plus court et de l'ordre de quelques nS

Ainsi chauffée, sous l'effet coopératif du chauffage de la sous-couche 4 par le flux d'amorçage 9 et du chauffage de la sous-couche 4 par le flux lumineux principal 6, la sous-couche d'amorçage 4, monte très rapidement en température et peut chauffer par diffusion thermique une partie 10 de la couche à chauffer 2 adjacente à la sous-couche d'amorçage 4 jusqu'à une température située dans la plage haute de température PHT pour rendre cette partie fortement absorbante.

Selon le mécanisme décrit précédemment, peut advenir une liquéfaction par chauffage de la couche 2 sur une zone correspondant approximativement à la zone d'application du flux lumineux principal 6, cette zone liquéfiée démarrant dans la zone 10 de la couche 2, à partir de laquelle le front thermique 11 progresse vers l'avant jusqu'à par exemple atteindre la face avant 3.

Dans cet exemple, l'effet coopératif du flux d'amorçage 9 et du flux principal 7 permet de chauffer très rapidement la couche d'amorçage, rendant ainsi le chauffage par diffusion thermique de la partie 10 plus rapide et permettant ainsi au profil de température de converger plus rapidement vers la température de saturation Tsat.

Après la fin de l'application du flux principal 7, la resolidification du matériau liquéfié peut éventuellement conduire à la formation de plus gros grains avec une orientation cristallographique préférentielle.

Dans ce procédé, la plaquette support 12 en silicium métallurgique n'est que très peu chauffée, limitant ainsi les risques de migration d'impuretés parasites de la plaquette vers la couche à chauffer 2.

Par balayage, on pourrait traiter toute la couche 2.

Une telle zone ainsi traitée, par liquéfaction puis solidification, peut présenter de meilleures propriétés électriques et peut être avantageuse pour la création de cellules photovoltaïques.

### Exemple 2.

On considère une plaquette de Silicium monocristallin dopé au niveau de 1E15/Cm2, de 100 microns d'épaisseur, constituant une couche 4.

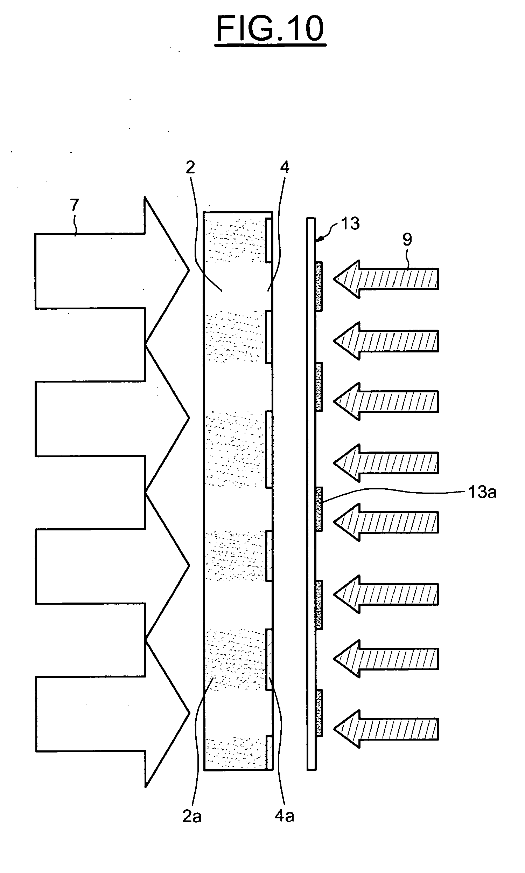

Comme le montre la **figure 10**, on envoie un flux d'un laser YAG doublé en fréquence (flux d'amorçage 9) sur la face arrière de la plaquette au travers d'un masque 13 composé d'une plaque mince de silice polie sur laquelle un dépôt de métal réfractaire et réfléchissant a été réalisé et gravé de façon à réaliser un dessin de zones opaques 13a et de zones transparentes entre ces zones opaques 13a.

Typiquement, le flux d'amorçage 9 peut se présenter sous la forme d'une impulsion d'une durée de 50 nS et transportant une densité d'énergie de l'ordre de 0,6 J/Cm2, ce qui correspond à une intensité de flux de 1,2*E7W/Cm2.On crée ainsi dans la plaquette (couche 4) des zones d'amorçage 4a dont la géométrie est à l'image du dessin du masque, conformément à l'exemple de la **figure 9**.

Le flux principal 7 peut être un flux de laser à fibre à la longueur d'onde de 1,55 microns. Le flux commence 100nS après la fin du flux d'amorçage 9 et présente une durée de l'ordre de 1,8 microseconde, avec des flux de puissance de l'ordre de 5*E6W/Cm2.

La chronologie du flux d'amorçage 9 et du flux principal 7 correspond à celle de la **figure 3**.

A la fin de l'application du flux d'amorçage 9, la température maximum obtenue peut être de l'ordre de 1700K.

Cent nanosecondes après la fin de l'impulsion d'amorçage, instant qui correspond au début de l'application du flux principal 7, la température maximum peut être alors d'environ 1400K.

Il convient de faire remarquer que le délai de 100nS qui est cité dans cet exemple entre la fin du flux d'amorçage et le début du flux principal, peut être avantageusement raccourci, de façon à bénéficier au mieux de l'élévation de température de la région d'amorçage. Un délai important de 100nS a été introduit dans cet exemple pour tenir compte d'une possible imparfaite synchronisation entre les deux flux 7 et 9.

La température Tsat obtenue peut être de l'ordre de 1680 K.

Le flux principal 7 chauffe la plaquette (couche 4) dans des régions d'amorçage 4a, alors que dans les régions ne correspondant pas aux zones d'amorçage 4a, il n'y a pas d'échauffement.

Le but d'un tel procédé peut par exemple être destiné à faire diffuser des impuretés, par exemple métalliques, dans les zones chauffées 2a sans que les impuretés des zones non chauffées ne diffusent.

Dans ce deuxième exemple, les caractéristiques et en particulier l'intensité du flux lumineux principal 7 et les caractéristiques du flux d'amorçage 9 peuvent être choisies telles que le flux principal 7 soit apte à compenser le flux de perte de température du profil thermique à l'instant correspondant au début du flux principal 7.

En effet, il peut être important que l'absorption du flux principal 7 résultant du profil de température existant à cet instant puisse compenser la tendance du profil de température à s'élargir et à s'affaisser du fait de la diffusion thermique. Si ce n'était pas le cas, l'abaissement du profil de température continuerait et le front thermique progressif 11 ne pourrait persister ou exister.

Le choix judicieux de ces caractéristiques peut être réalisé en simulant l'évolution des profils thermiques par la méthode dite des différences finies en géométrie 1D, méthode qui fait partie de l'état de l'art et pour laquelle il existe des logiciels standards.

Dans une variante, le chauffage de la couche ou région d'amorçage 4 pourrait être obtenu par le rayonnement d'une lampe à arc de très forte puissance concentré par une lentille.

## Revendications

1. Procédé de chauffage, au moins local, d'une plaque (1) comprenant au moins une couche à chauffer (2) au moins localement, jusqu'à un niveau de température à atteindre, sous l'effet d'au moins une impulsion d'un flux lumineux principal, et comprenant au moins une région d'amorçage (4) située en profondeur par rapport à une face frontale de ladite couche à chauffer,
procédé dans lequel la longueur d'onde dudit flux lumineux principal (7) est choisie de telle sorte que le coefficient d'absorption de ce flux par la matière de la couche à chauffer (2) est faible tant que la température de la matière de cette couche à chauffer est dans une plage basse de température (PBT) et que ce coefficient d'absorption augmente fortement avec la température quand la température de la matière de la couche à chauffer passe dans une plage haute de température (PHT) située approximativement au-dessus de cette plage basse de température, la zone de transition (TT) entre la plage basse de température (PBT) et la plage haute de température (PHT) étant située au-dessous dudit niveau de température à atteindre (Tsat), les caractéristiques dudit flux lumineux principal (7) étant telles qu'il est, à lui seul, inapte à chauffer directement la matière de la couche à chauffer depuis une température située dans ladite plage basse de température (PBT) jusqu'à une température située dans ladite plage haute de température (PHT) ; le procédé comprenant les étapes suivantes :
chauffage de ladite région d'amorçage (4) de ladite plaque, au moins partiellement sous l'effet d'un moyen de chauffage secondaire d'amorçage (9), de telle sorte que ladite région d'amorçage (4) chauffe par diffusion thermique une partie (10) de la couche à chauffer (2) adjacente à ou proche de cette région d'amorçage (4) jusqu'à une température située dans ladite plage haute de température (PHT) pour rendre cette partie fortement absorbante dudit flux principal lumineux (6) ;
application dudit flux principal lumineux (6) à ladite plaque (1), au moins localement, par ladite face frontale (3) de ladite couche à chauffer (2), de telle sorte que, ladite partie (10) adjacente à ou proche de ladite couche à chauffer (2), devenue fortement absorbante, générant un front thermique absorbant (11) dont la température est située dans ladite plage haute de température (PHT), ce front thermique absorbant (11) progresse vers ladite face avant (3) sous l'effet conjugué d'une diffusion thermique vers l'avant du front thermique (11) et d'un apport d'énergie thermique par ledit flux lumineux principal (7) qui atteint le front thermique dès lors que la température du front thermique passe dans ladite plage haute de température (PHT).

2. Procédé selon la revendication 1, **caractérisé en ce que** ladite région d'amorçage (4) est en une matière différente de celle de la couche à chauffer.

3. Procédé selon l'une des revendications 1 et 2, dans lequel le début de l'application dudit flux principal lumineux (7) correspond approximativement à la fin de l'application dudit moyen de chauffage secondaire d'amorçage (9).

4. Procédé selon l'une des revendications 1 et 2, dans lequel le début de l'application dudit flux principal lumineux (7) est situé avant la fin de l'application dudit moyen de chauffage secondaire d'amorçage (9).

5. Procédé selon la revendication 4, dans lequel ledit flux principal lumineux (6) est choisi de façon à être absorbé par ladite région d'amorçage (4), le chauffage de ladite région d'amorçage étant réalisé sous l'effet dudit moyen de chauffage secondaire d'amorçage (9) et sous l'effet dudit flux principal lumineux (7).

6. Procédé selon l'une quelconque des revendications précédentes, dans lequel ledit moyen de chauffage secondaire d'amorçage (9) est appliqué par ladite face frontale (3) de ladite couche à chauffer (2) et/ou par une face de ladite plaque opposée à cette face frontale.

7. Procédé selon l'une quelconque des revendications précédentes, dans lequel ledit moyen de chauffage secondaire d'amorçage est un flux thermique généré par une source de chaleur.

8. Procédé selon l'une quelconque des revendications précédentes, dans lequel ledit moyen de chauffage secondaire d'amorçage est un flux de particules, ladite région d'amorçage étant chauffée par l'énergie résultant du freinage et/ou de l'arrêt de ces particules dans ladite région d'amorçage.

9. Procédé selon l'une quelconque des revendications précédentes, dans lequel ledit moyen de chauffage secondaire d'amorçage est un flux de rayonnement, ladite région d'amorçage (4) étant chauffée par absorption de ce rayonnement.

10. Procédé selon l'une quelconque des revendications précédentes, dans lequel ladite région d'amorçage (4) est formée par une partie de ladite couche à chauffer.

11. Procédé selon l'une quelconque des revendications précédentes, dans lequel ladite région d'amorçage (4) est formée par une sous-couche adjacente à ou proche de ladite couche à chauffer.

12. Procédé selon l'une quelconque des revendications précédentes, dans lequel ladite plage basse de température (PBT) et ladite plage haute de température (PHT) sont séparées par un seuil de transition de comportement du coefficient d'absorption en fonction de la température.

13. Procédé selon l'une quelconque des revendications précédentes, dans lequel la couche à chauffer (2) est du silicium peu dopé.

14. Procédé selon l'une quelconque des revendications précédentes, dans lequel la couche à chauffer (2) est un matériau semi-conducteur.

15. Procédé selon l'une quelconque des revendications précédentes, dans lequel le flux principal lumineux (7) est généré par un laser.

## Claims

1. Method for at least locally heating a plate (1) including at least one layer (2) to be at least locally heated, up to a temperature level to reach, by at least one main light flow pulse, and including at least one priming region (4) located deeply relative to the front surface of said layer to be heated,
method wherein the wavelength of said main light flow (7) is chosen such that the coefficient of absorption of said flow by the material of the layer to be heated (2) is low while the temperature of the material of said layer to be heated is in a low temperature range (PBT) and that this absorption coefficient sharply increases with temperature when the temperature of the material of the layer to be heated passes into a high temperature range (PHT) approximately above said low temperature range, the transition zone (TT) between the low temperature range (PBT) and the high temperature range (PHT) being situated below said temperature level to reach (Tsat), the characteristics of said main light flow (7) being such that it is, on its own, incapable of heating directly the material of the layer to be heated from a temperature within said low temperature range (PBT) up to a temperature within said high temperature range (PHT);
the method comprising the following steps:
heating said priming region (4) of said plate, at least partially by a priming secondary heating means (9), such that said priming region (4) heats through thermal diffusion a portion (10) of the layer to be heated (2) adjacent to or close to said priming region {4} up to a temperature within said high temperature range (PHT) to make this portion highly absorbent of said main light flow {6};
application of said main light flow (6) to said plate (1), at least locally, by said front surface (3) of said layer to be heated (2), such that, said portion (10) adjacent to or near to said layer to be heated (2), which has become highly absorbent, generating an absorbent thermal front (11), the temperature of which is within said high temperature range (PHT), said absorbent thermal front (11) progresses towards said front surface (3) under the combined effect of a thermal diffusion towards the front of the thermal front (11) and an input of thermal energy by said main light flow (7) which reaches the thermal front as soon as the temperature of the thermal front passes into said high temperature range (PHT),

2. Method according to claim 1, **characterized in that** said priming region (4) is made of a material different to that of the layer to be heated.

3. Method according to one of claims 1 and 2, wherein the start of the application of said main light flow (7) approximately corresponds to the end of the application of said priming secondary heating means (9).

4. Method according to one of claims 1 and 2, wherein the start of the application of said main light flow (7) is before the end of the application of said priming secondary heating means (9}.

5. Method according to claim 4, wherein said main light flow (6) is chosen so as to be absorbed by said priming region (4), the heating of said priming region being realised by said priming secondary heating means (9) and by said main light flow (7).

6. Method according to any of the preceding claims, wherein said priming secondary heating means (9) are applied by said front surface (3) of said layer to be heated (2) and/or by one surface of said plate opposite to said front surface.

7. Method according to any of the preceding claims, wherein said priming secondary heating means are a heat flow generated by a heat source.

8. Method according to any of the preceding claims, wherein said priming secondary heating means are a flow of particles, said priming region being heated by the energy resulting from the slowing down and/or the stopping of said particles in said priming region.

9. Method according to any of the preceding claims, wherein said priming secondary heating means are a radiation flow, said priming region (4) being heated by absorption of said radiation.

10. Method according to any of the preceding claims, wherein said priming region (4) is formed by a portion of said layer to be heated.

11. Method according to any of the preceding claims, wherein said priming region (4) is formed by a sub-layer adjacent to or near to said layer to be heated.

12. Method according to any of the preceding claims, wherein said low temperature range (PBT) and said high temperature range (PHT) are separated by a transition threshold of the behaviour of the absorption coefficient as a function of temperature.

13. Method according to any of the preceding claims, wherein the layer to be heated (2) is lightly doped silicon.

14. Method according to any of the preceding claims, wherein the layer to be heated (2) is a semiconductor material.

15. Method according to any of the preceding claims, wherein the main light flow (7) is generated by a laser.

## Patentansprüche

1. Verfahren zum Erhitzen, und dies wenigstens lokal und bis auf ein zu erreichendes Temperaturniveau und unter Einwirkung wenigstens eines Impulses eines Hauptlichtflusses, einer Platte (1), die wenigstens eine wenigstens lokal zu erhitzende Schicht (2) umfasst und die wenigstens einen Auslösebereich (4) umfasst, der sich in Bezug auf eine Vorderseite der zu erhitzenden Schicht in der Tiefe befindet,
wobei in dem Verfahren die Wellenlänge des Hauptlichtflusses (7) so gewählt ist, dass der Absorptionskoeffizient für diesen Fluss im Material der zu erhitzenden Schicht (2) niedrig ist, solange die Temperatur des Materials der zu erhitzenden Schicht in einem niedrigen Temperaturbereich (PBT) liegt, und dass dieser Absorptionskoeffizient mit der Temperatur stark ansteigt, wenn die Temperatur des Materials der zu erhitzenden Schicht in einen hohen Temperaturbereich (PHT) kommt, der sich in etwa oberhalb des niedrigen Temperaturbereichs befindet, wobei die Übergangszone (TT) zwischen dem niedrigen Temperaturbereich (PBT) und dem hohen Temperaturbereich (PHT) sich unterhalb des zu erreichenden Temperaturniveaus (Tsat) befindet und wobei die Eigenschaften des Hauptlichtflusses (7) derart sind, dass er alleine nicht dazu in der Lage ist, das Material der zu erhitzenden Schicht direkt von einer Temperatur, die im niedrigen Temperaturbereich (PBT) liegt, bis auf eine Temperatur, die im hohen Temperaturbereich (PHT) liegt, zu erhitzen;
wobei das Verfahren die folgenden Schritte umfasst:
Erhitzen des Auslösebereichs (4) der Platte, und dies wenigstens teilweise unter Einwirkung eines sekundären Erhitzungsmittels zum Auslösen (9) und derart, dass der Auslösebereich (4) durch thermische Diffusion einen Teil (10) der zu erhitzenden Schicht (2), der benachbart zur oder nahe bei dem Auslösebereich (4) liegt, erhitzt, und dies bis auf eine Temperatur, die im hohen Temperaturbereich (PHT) liegt, um diesen Teil für den Hauptlichtfluss (6) stark absorbierend zu machen;
Anwenden des Hauptlichtflusses (6) auf die Platte (1), und dies wenigstens lokal und über die Vorderseite (3) der zu erhitzenden Schicht (2), sowie derart, dass der Teil (10), der benachbart zur oder nahe bei der zu erhitzenden Schicht (2) liegt und der stark absorbierend geworden ist, eine thermische absorbierende Front (11) erzeugt, deren Temperatur im hohen Temperaturbereich (PHT) liegt, wobei die thermische absorbierende Front (11) in Richtung der Vorderseite (3) fortschreitet, und dies unter der kombinierten Einwirkung einer thermischen Diffusion in Richtung der Vorderseite der thermischen Front (11) und eines Eintrags an thermischer Energie durch den Hauptlichtfluss (7), der auf die thermische Front einwirkt, sobald die Temperatur der thermischen Front in den hohen Temperaturbereich (PHT) kommt.

2. Verfahren nach Anspruch 1, **dadurch gekennzeichnet, dass** der Auslösebereich (4) aus einem Material ist, das von demjenigen der zu erhitzenden Schicht verschieden ist.

3. Verfahren nach einem der Ansprüche 1 und 2, bei dem der Beginn der Anwendung des Hauptlichtflusses (7) in etwa dem Ende der Anwendung des sekundären Erhitzungsmittels zum Auslösen (9) entspricht.

4. Verfahren nach einem der Ansprüche 1 und 2, bei dem der Beginn der Anwendung des Hauptlichtflusses (7) vor dem Ende der Anwendung des sekundären Erhitzungsmittels zum Auslösen (9) liegt.

5. Verfahren nach Anspruch 4, bei dem der Hauptlichtfluss (6) so gewählt ist, dass er vom Auslösebereich (4) absorbiert wird, wobei das Erhitzen des Auslösebereichs unter der Einwirkung des sekundären Erhitzungsmittels zum Auslösen (9) und unter der Einwirkung des Hauptlichtflusses (7) ausgeführt wird.

6. Verfahren nach einem der vorhergehenden Ansprüche, bei dem das sekundäre Erhitzungsmittel zum Auslösen (9) über die Vorderseite (3) der zu erhitzenden Schicht (2) und/oder über eine Seite der Platte, die entgegengesetzt zur Vorderseile liegt, angewendet wird.

7. Verfahren nach einem der vorhergehenden Ansprüche, bei dem das sekundäre Erhitzungsmittel zum Auslösen ein thermischer Fluss ist, der von einer Wärmequelle erzeugt wird.

8. Verfahren nach einem der vorhergehenden Ansprüche, bei dem das sekundäre Erhitzungsmittel zum Auslösen ein Teilchenfluss ist, wobei der Auslösebereich durch die Energie erhitzt wird, die aus der Abbremsung und/oder dem Stoppen der Teilchen im Auslösebereich resultiert.

9. Verfahren nach einem der vorhergehenden Ansprüche, bei dem das sekundäre Erhitzungsmittel zum Auslösen ein Strahlungsfluss ist, wobei der Auslösebereich (4) durch die Absorption der Strahlung erhitzt wird.

10. Verfahren nach einem der vorhergehenden Ansprüche, bei dem der Auslösebereich (4) durch einen Teil der zu erhitzenden Schicht gebildet wird.

11. Verfahren nach einem der vorhergehenden Ansprüche, bei dem der Auslösebereich (4) durch eine Unterschicht gebildet wird, die benachbart zur oder nahe bei der zu erhitzenden Schicht liegt.

12. Verfahren nach einem der vorhergehenden Ansprüche, bei dem der niedrige Temperaturbereich (PBT) und der hohe Temperaturbereich (PHT) durch einen Schwellwert für den Übergang des Verhaltens des Absorptionskoeffizienten in Abhängigkeit von der Temperatur getrennt sind.

13. Verfahren nach einem der vorhergehenden Ansprüche, bei dem die zu erhitzende Schicht (2) aus wenig dotiertem Silizium besteht.

14. Verfahren nach einem der vorhergehenden Ansprüche, bei dem die zu erhitzende Schicht (2) ein Halbleitermaterial ist.

15. Verfahren nach einem der vorhergehenden Ansprüche, bei dem der Hauptlichtfluss (7) durch einen Laser erzeugt wird.
